# EUROPEAN PATENT APPLICATION

(11) **EP 3 553 944 A1**
(43) Date of publication of application: **16.10.2019**
(21) Application number: 18275151.1
(22) Date of filing: 28.09.2018
(51) Int. Cl.: H02S 20/25, E04D 1/30, E04D 1/36

(54) **TILE, TILE ASSEMBLY, AND METHOD OF FABRICATING A TILE**

(30) Priority: 13.04.2018 CN 201810332903
(71) Applicant: Beijing Hanergy Solar Power Investment Co., Ltd., 101499 Beijing (CN)
(72) Inventor: HU, Baoyi, Beijing 101499 (CN); ZHAO, Xiaohui, Beijing 101499 (CN)
(74) Representative: Potter Clarkson

(57) **Abstract**

A tile, a tile assembly and a method of fabricating a tile are provided. The tile includes: an arc-shaped tile body including a first end and a second end in its length direction; and an arc-shaped jacket including a fixing section and a mounting section sequentially disposed in its length direction, a convex side surface of the fixing section is attached and fixed to a concave side surface of the first end of the tile body, the mounting section protrudes from an end surface of the first end of the tile body, and a convex side surface of the mounting section can be attached to a concave side surface of the second end of the tile body of another tile, the convex side surface of the jacket is provided with a drainage groove between the fixing section and the mounting section and extending along a width direction of the jacket.

## Description

### Technical Field

The present disclosure relates to the technical field of building tiles, and in particular to a tile, a tile assembly, and a method of fabricating a tile.

### Background Art

Tiles, which are applied to buildings, not only serve for heat insulation and protection against rain, but also have beautiful and tidy appearance and high durability. In the prior art, a roof surface is usually covered by a plurality of tiles which are lap-jointed sequentially, however situations such as water leakage are prone to occur due to the presence of a lap-joint gap at the lap-jointed position where two tiles are lap-jointed together, thus the tiles cannot serve for effective protection against rain.

### Summary

Embodiments of the present disclosure provide a tile, including an arc-shaped tile body (e.g., arc sheet-like tile body) and an arc-shaped jacket (e.g., arc sheet-like tile body), wherein the tile body includes a first end and a second end, the first end and the second end being two ends of the tile body in the length direction of the tile body own; the jacket includes a fixing section and a mounting section sequentially disposed along the length direction of the tile body own, a convex side surface of the fixing section is attached and fixed to a concave side surface of the first end of the tile body, the mounting section protrudes out from an end surface of the first end of the tile body, and a convex side surface of the mounting section can be attached to a concave side surface of the second end of a tile body of another tile, the convex side surface of the jacket is provided with a drainage groove, the drainage groove is located between the fixing section and the mounting section, and the drainage groove extends along a width direction of the jacket.

Optionally, a sectional shape of the drainage groove is a semicircle, a square or a triangle.

Optionally, the arc-shaped tile body is a semicircular tile, a combined tile or a ridge tile.

Optionally, the convex side surface of the fixing section and the concave side surface of the first end of the arc-shaped tile body are adhesively fixed to each other by a foam adhesive or a silica gel, or fixed to each other by a screw.

Optionally, the drainage groove runs through the jacket in the width direction of the jacket.

Optionally, the jacket further comprises a stop, the stop is located between the fixing section and the drainage groove, and the stop is configured to abut against the end surface of the first end of the tile body.

Optionally, the jacket further comprises a stop, the stop is located between the fixing section and the mounting section, and the stop is configured to abut against the end surface of the first end of the tile body.

Optionally, an elastic layer is provided on the convex side surface of the mounting section.

Optionally, the elastic layer is an elastic layer made of rubber, silica gel, or sponge.

Optionally, the tile body is light-transmissible, and a photovoltaic cell layer is provided on the concave side surface of the tile body.

Optionally, the photovoltaic cell layer is attached onto the concave side surface of the tile body, or the photovoltaic cell layer is formed directly on the concave side surface of the tile body, or the photovoltaic cell layer is adhered to and covers the concave side surface of the tile body by using a whole layer of a first adhesive layer.

Optionally, the photovoltaic cell layer is a flexible photovoltaic cell layer.

Optionally, the tile body is a tempered glass tile body or a polycarbonate tile body.

Optionally, the tile further comprises a back plate, wherein the back plate covers and is fixed onto a side surface of the photovoltaic cell layer away from the tile body.

Optionally, the back plate is a flexible back plate.

Optionally, the mounting section is provided with a fixing hole, with the fixing hole configured to allow a connector to pass therethrough, with the connector capable of fixing the tile to a roof structure.

Embodiments of the present disclosure further provide a tile assembly, which comprises tiles described above and which has all the functions of the tile.

Embodiment of the present disclosure further provide a method of fabricating a tile, the tile including an arc-shaped tile body, a flexible photovoltaic cell layer, and a flexible back plate, the photovoltaic cell layer being disposed on a concave side surface of the tile body, the back plate covering and being fixed to a side surface of the photovoltaic cell layer away from the tile body, and the method including: attaching and fixing the photovoltaic cell layer to the back plate to form a flexible photovoltaic cell module; and attaching and fixing the photovoltaic cell module to the concave side surface of the tile body, and making the back plate cover a side of the photovoltaic cell layer away from the tile body.

Embodiments of the present disclosure further provides a method of fabricating the tile described above, the fabricating method including: forming the drainage groove in the convex side surface of the jacket; and attaching and fixing the convex side surface of the fixing section of the jacket to the concave side surface of the first end of the tile body, so that the mounting section of the jacket protrudes out from the end surface of the first end of the tile body.

### Brief Description of Drawings

For illustrating technical solutions of embodiments of the present disclosure or of the prior art more clearly, drawings required for use in the description of the embodiments or the prior art will be introduced briefly below. It is obvious that the drawings in the following description are merely illustrative of some embodiments of the present disclosure. It would be understood by those of ordinary skill in the art that other relevant drawings could also be obtained from these drawings without any inventive efforts.
FIG. 1 is a perspective view of a tile of an embodiment of the present disclosure;
FIG. 2 is an exploded view of a tile of an embodiment of the present disclosure;
FIG. 3 is a top view of a tile of an embodiment of the present disclosure;
FIG. 4 is a sectional view of the tile shown in FIG. 3 along a line A-A;
FIG. 5 is a partial enlarged view of Area I in FIG. 4; and
FIG. 6 is a flowchart of a method of fabricating a tile of an embodiment of the present disclosure.

Reference Numerals: 1-tile body; 11-first end; 12-second end; 2-photovoltaic cell layer; 3-jacket; 31-fixing section; 32-mounting section; 33-stop; 34-drainage groove; 4-first adhesive layer; 5-elastic layer; 6-back plate; 7-second adhesive layer; 8-fixing hole.

### Detailed Description of Embodiments

The technical solutions of embodiments of the present disclosure will be described clearly and completely below with reference to the accompanying drawings of the embodiments of the present disclosure. It is apparent that the embodiments to be described are some, but not all of the embodiments of the present disclosure. All the other embodiments obtained by those of ordinary skill in the art in light of the embodiments of the present disclosure without inventive efforts should fall within the scope of the present disclosure as claimed.

In the description of the present disclosure, it should be understood that orientation or positional relations indicated by the terms such as "center", "up", "down", "front", "rear", "left", "right", "vertical", "horizontal", "top", "bottom", "inside", and "outside" are the orientation or positional relations shown based on the figures, and these terms are intended only to facilitate the description of the present disclosure and simplify the description, but not intended to indicate or imply that the referred devices or elements must be in a particular orientation or constructed or operated in the particular orientation, and therefore should not be construed as limiting the present disclosure. In the description of the present disclosure, the phrase "a plurality of" means two or more unless otherwise stated.

In the description of the present disclosure, it should be noted that the terms "mounted", "coupled", and "connected" should be understood broadly unless otherwise expressly specified or defined. For example, connection may be fixed connection or detachable connection or integral connection, may be mechanical connection, or may be direct coupling or indirect coupling via an intermediate medium or internal communication between two elements. The specific meanings of the above-mentioned terms in the present disclosure could be understood by those of ordinary skill in the art according to specific situations.

It should be noted that the features in the embodiments of the present disclosure may be combined with each other without conflict.

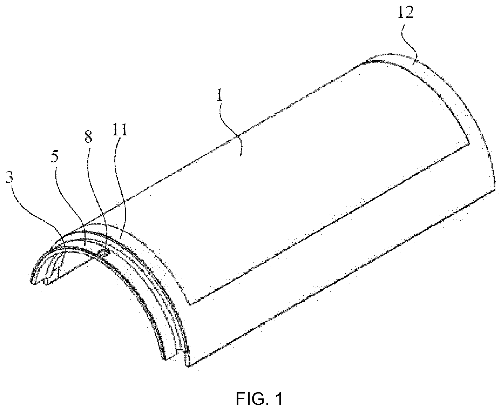

Referring to FIG. 1 to FIG. 5, FIG. 1 to FIG. 5 show a tile according to embodiments of the present disclosure. The tile comprises an arc-shaped tile body 1 (e.g., arc sheet-like tile body) and an arc-shaped jacket 3 (e.g., arc sheet-like jacket), wherein the tile body 1 comprises a first end 11 and a second end 12, and the first end 11 and the second end 12 are two ends of the tile body 1 in its own length direction; the jacket 3 comprises a fixing section 31 and a mounting section 32 sequentially disposed in the length direction of the jacket own, a convex side surface of the fixing section 31 is attached and fixed to a concave side surface of the first end 11 of the tile body 1 (the shape of the convex side surface of the fixing section 31 is matched with the shape of the concave side surface of the first end 11 of the tile body 1), the mounting section 32 protrudes out from an end surface of the first end 11 of the tile body 1, and a convex side surface of the mounting section 32 is configured to be attached to a concave side surface of a second end 12 of a tile body of another tile, the convex side surface of the jacket 3 is provided thereon with a drainage groove 34, the drainage groove 34 is located between the fixing section 31 and the mounting section 32, and the drainage groove 34 extends in a width direction of the jacket 3.

The tile according to an embodiment of the present disclosure comprises an arc-shaped tile body 1 and an arc-shaped jacket 3, wherein the tile body 1 comprises a first end 11 and a second end 12, and the first end 11 and the second end 12 are two ends of the tile body 1 in its own length direction; the jacket 3 comprises a fixing section 31 and a mounting section 32 sequentially disposed in the length direction of the jacket, a convex side surface of the fixing section 31 is attached and fixed to a concave side surface of the first end 11 of the tile body 1, the mounting section 32 protrudes out from an end surface of the first end 11 of the tile body 1, and a convex side surface of the mounting section 32 is configured to be attached to a concave side surface of a second end 12 of a tile body of another tile. In this way, when the tile is used to cover a roof surface, the tile may be placed with the convex side surface facing upward and the concave side surface facing downward, and at the same time, the concave side surface of the second end 12 of the tile body of a tile is made to be lap-jointed on the convex side surface of the mounting section 32 of another tile, thereby sequentially achieving the lap-jointing of a plurality of tiles to cover the roof surface. Moreover, the convex side surface of the jacket 3 is provided thereon with a drainage groove 34, the drainage groove 34 is located between the fixing section 31 and the mounting section 32, and the drainage groove 34 extends in the width direction of the jacket 3, therefore rainwater, entering from a gap between two tiles which are lap-jointed together, may be discharged to two sides of the tile under the action of the drainage groove 34, and discharged by the drainage groove 34 provided at two sides of the tile, thereby preventing penetration of rainwater beneath the tile so as to improve the rainproof property of the tile.

It should be noted that in the embodiment of the present disclosure, the length direction of the arc-shaped tile body 1 refers to a direction perpendicular to a plane where an arcuate contour line of the tile body 1 is located, the width direction of the arc-shaped tile body 1 refers to a direction in which the arcuate contour line of the tile body 1 extends, the length direction of the arc-shaped jacket 3 refers to a direction perpendicular to a plane where an arcuate contour line of the jacket 3 is located, and the width direction of the arc-shaped jacket 3 refers to a direction in which the arcuate contour line of the jacket 3 extends.

The length direction of the tile body 1 may also be considered to refer to a direction from the first end 11 to the second end 12 of the tile body 1. Generally, when mounted, a plurality of tiles are lap-jointed mutually, the first end 11 is adjacent to the tile body of a previous tile, and the second end 12 is adjacent to the tile body of a next tile, that is to say, the first end 11 and the second end 12 of the tile body 1 are oppositely located at two ends of the tile body 1. The width direction of the tile body 1 may also be considered to refer to a circumferential direction of the arc-shaped tile body 1. Similarly, the length direction of the jacket 3 may also be considered to refer to a direction from a portion of the jacket 3 attached to the tile body 1 to a portion of the jacket 3 attached to the tile body of another tile, and the width direction of the jacket 3 may also be considered to refer to a circumferential direction of the arc-shaped jacket 3. Meanwhile, when the jacket 3 is attached and fixed to the tile body 1, the length direction of the jacket 3 coincides with the length direction of the tile body 1, and the width direction of the jacket 3 coincides with the width direction of the tile body 1. In the embodiments shown in FIG. 1 to FIG. 5, the sectional shape of the drainage groove 34 may be a semicircle, a square, a triangle, or the like, and is not specifically limited herein.

In the embodiments shown in FIG. 1 to FIG. 5, the tile body 1 may be a semicircular tile (imbrex), or may also be a combined tile (i.e. a tile formed by combining two overlapped pan tiles, with one pan tile facing upwards and the other one facing downwards) or a ridge tile, and is not specifically limited herein.

In the embodiments shown in FIG. 1 to FIG. 5, the convex side surface of the fixing section 31 and the concave side surface of the first end 11 of the tile body 1 may be adhesively fixed by a foam adhesive, a silica gel, or the like, or may also be fixed by a connector such as a screw or a snap-fit structure, which is not specifically limited herein. In the present embodiment, optionally, the convex side surface of the fixing section 31 and the concave side surface of the first end 11 of the tile body 1 are adhesively fixed to each other by a foam adhesive, a silica gel, or the like. In this way, the strength of the connection between the fixing section 31 and the tile body 1 can be ensured, and simultaneously, the provision of a connection hole in the tile body 1 is avoided, so as to avoid leakage of water from the tile through the connection hole.

Still further, the jacket 3 may be a metal jacket, a plastic jacket, a ceramic jacket, or the like, and is not specifically limited herein. In the present embodiment, optionally, the jacket 3 is a metal jacket. The metal material has good structural stability, long service life, and simple molding process, thus the lifetime of the jacket 3 can be prolonged, and the complexity of fabrication of the jacket 3 can be reduced.

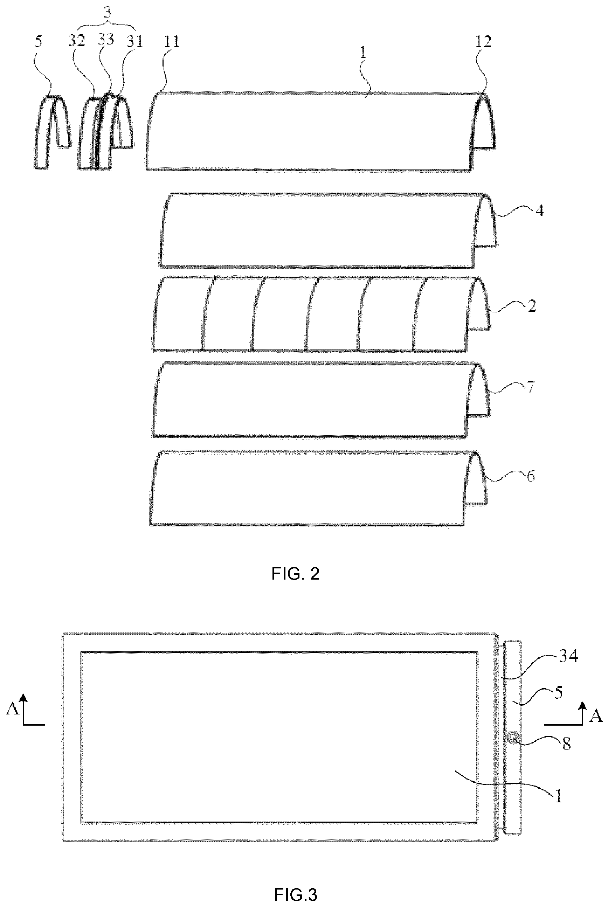

In the embodiments shown in FIG. 1 to FIG. 5, the length of the drainage groove 34 is not specifically limited. Optionally, in order to completely discharge rainwater to two sides of the tile, with the rainwater entering from the gap between two tiles which are lap-jointed together, the drainage groove 34 runs through the jacket 3 along the width direction of the jacket 3, as shown in FIG. 3. In this way, the drainage groove 34 enables rainwater entering from the gap between two tiles which are lap-jointed together to be completely discharged to two sides of the tile.

The drainage groove 34 running through the jacket 3 along the width direction of the jacket 3 may also be considered as the drainage groove 34 running through the jacket 3 along the circumferential direction of the jacket 3, or as the drainage groove 34 extending from the top to two bottoms of the jacket 3 and running through the bottoms thereof, so that rainwater flowing in from the top can flow to the bottoms along the direction of extension of the drainage groove 34 and be discharged from the bottoms.

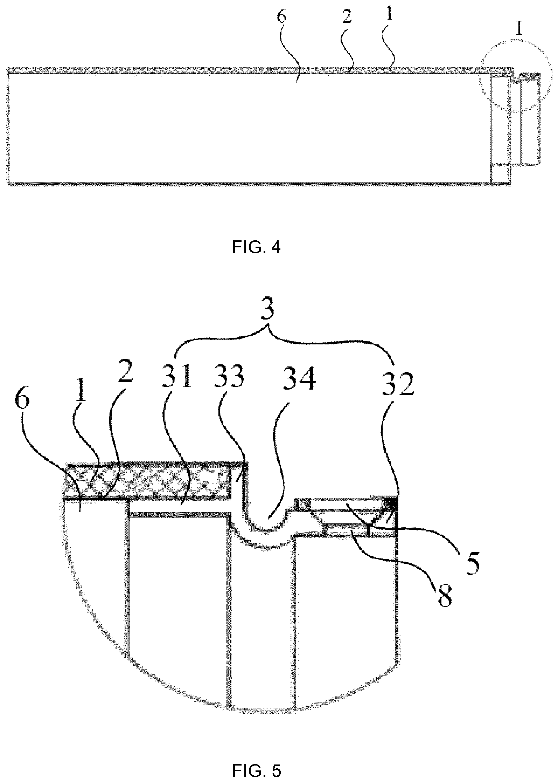

In order to protect the end surface of the first end 11 of the tile body 1 and avoid collision of the tile body 1 of another tile with the tile body 1 of this tile when tile body of the another tile is lap-jointed on the lap-jointed portion of this tile, optionally, as shown in FIG. 2 and FIG. 5, the jacket 3 further comprises a stop 33, wherein the stop 33 is located between the fixing section 31 and the mounting section 32, and the stop 33 abuts against the end surface of the first end 11 of the tile body 1. In this way, the end surface of the first end 11 of the tile body 1 can be protected by the stop 33, and breakage or crack of two tile bodies 1 due to collision therebetween can be avoided.

Meanwhile, the stop 33 is also located between the fixing section 31 and the drainage groove 34.

In order to elastically support a tile lap-jointed on the mounting section 32, optionally, as shown in FIG. 1 and FIG. 2, an elastic layer 5 is disposed on the convex side surface of the mounting section 32, and the tile lap-jointed on the mounting section 32 can be elastically supported by the elastic layer 5.

In the embodiment described above, the elastic layer 5 may be disposed on the convex side surface of the mounting section 32 by means of gluing adhesion, or may also be fixed onto the convex side surface of the mounting section 32 by a screwed connection structure or a snap-fit structure, which is not specifically limited herein.

In addition, the elastic layer 5 may be an elastic layer made of rubber, silica gel, sponge, or the like, and is not specifically limited herein. However, in order to effectively seal the gap between the mounting section 32 and a tile lap-jointed on the mounting section 32, optionally, the elastic layer 5 is an elastic layer made of rubber. Rubber has excellent elasticity and good sealing performance, so that the gap between the mounting section 32 and the tile lap-jointed on the mounting section 32 can be effectively sealed.

In the embodiments shown in FIG. 1 to FIG. 5, the tile body 1 may be either a light-transmissive tile body or an opaque tile body, and is not specifically limited herein. Optionally, the tile body 1 is light-transmissible, and a photovoltaic cell layer 2 is disposed on the concave side surface of the tile body 1. In this way, the tile can convert light energy irradiated thereon into electrical energy for use by the user, thus light energy (such as solar energy) resources are effectively utilized.

In the embodiment described above, it should be noted that the arrangement of the photovoltaic cell layer 2 on the concave side surface of the tile body 1 means that the photovoltaic cell layer 2 covers an entire or partial area of the concave side surface of the tile body 1, and the curvature of the photovoltaic cell layer 2 is consistent or approximately consistent with the curvature of the concave side surface of the tile body 1. It can be understood that when their curvatures are consistent or approximately consistent with each other, they can achieve close attachment, and there is substantially no gap between them, or the normal use is not affected even if there is a gap between them.

In addition, the tile body 1 may be a light-transmissive tile body such as a tempered glass tile body or a polycarbonate tile body, and is not specifically limited herein.

Furthermore, the photovoltaic cell layer 2 may be disposed on the concave side surface of the tile body 1 by means of gluing adhesion, or may also be fixed onto the concave side surface of the tile body 1 by a screwed connection structure or a snap-fit structure, which is not specifically limited herein. When the photovoltaic cell layer 2 is disposed on the concave side surface of the tile body 1 by gluing adhesion, optionally, the photovoltaic cell layer 2 may be adhered to and cover the concave side surface of the tile body 1 by a spot-like adhesive, a linear adhesive, or a whole layer of a first adhesive layer 4, which is not specifically limited herein. In the present embodiment, optionally, as shown in FIG. 2, the photovoltaic cell layer 2 is adhered to and covers the concave side surface of the tile body 1 by a whole layer of the first adhesive layer 4. In this way, the connection between the photovoltaic cell layer 2 and the tile body 1 has higher strength, and the first adhesive layer 4 can effectively block a gap between the photovoltaic cell layer 2 and the tile body 1, to prevent impurities from intruding into the gap and affecting the power generation efficiency and service life of the tile.

Further, the photovoltaic cell layer 2 may be either a flexible photovoltaic cell layer or a rigid photovoltaic cell layer, and is not specifically limited herein. However, in order to facilitate the attachment of the photovoltaic cell layer 2 onto the concave side surface of the tile body 1, optionally, the photovoltaic cell layer 2 is a flexible photovoltaic cell layer. The flexible photovoltaic cell layer is freely bendable to adapt to the curvature of the concave side surface of the tile body 1, thereby facilitating the operation of attaching the photovoltaic cell layer 2 to the concave side surface of the tile body 1. Of course, it is also possible that the photovoltaic cell layer 2 is formed directly on the concave side surface of the tile body 1.

In the embodiments shown in FIG. 1 to FIG. 5, optionally, the flexible photovoltaic cell layer 2 is a thin film solar cell. The thin film solar cell is a commonly-used flexible photovoltaic cell, and thus is easy to implement.

In order to encapsulate the photovoltaic cell layer 2, optionally, as shown in FIG. 2, the tile further comprises a back plate 6, with the back plate 6 covering and being fixed onto a side surface of the photovoltaic cell layer 2 away from the tile body 1. In this way, the photovoltaic cell layer 2 is encapsulated by the back plate 6, to avoid direct contact of water or dust with the photovoltaic cell layer 2 which would affect the lifetime of the photovoltaic cell layer 2.

In the embodiment described above, it should be noted that the back plate 6 covering and being fixed onto a side surface of the photovoltaic cell layer 2 away from the tile body 1 means that the back plate 6 covers and is fixed onto an entire area of the side surface of the photovoltaic cell layer 2 away from the tile body 1, and the curvature of the back plate 6 is consistent or approximately consistent with the curvature of the side surface of the photovoltaic cell layer 2 away from the tile body 1. It can be understood that when their curvatures are consistent or approximately consistent with each other, they can achieve close attachment, and there is substantially no gap between them, or the normal use is not affected even if there is a gap between them.

In addition, the back plate 6 may be fixed onto the side surface of the photovoltaic cell layer 2 away from the tile body 1 by means of gluing, or may also be fixed onto the side surface of the photovoltaic cell layer 2 away from the tile body 1 by a connector such as a screw or a snap-fit structure, which is not specifically limited herein. When the back plate 6 is fixed onto the side surface of the photovoltaic cell layer 2 away from the tile body 1 by means of gluing, optionally, the back plate 6 may be adhesively fixed onto the side surface of the photovoltaic cell layer 2 away from the tile body 1 by a spot-like adhesive, a linear adhesive, or a whole layer of a second adhesive layer 7, which is not specifically limited herein. In the present embodiment, optionally, as shown in FIG. 2, the back plate 6 may be adhesively fixed onto the side surface of the photovoltaic cell layer 2 away from the tile body 1 by a whole layer of the second adhesive layer 7. In this way, the connection between the back plate 6 and the photovoltaic cell layer 2 has higher strength, and the second adhesive layer 7 can effectively block a gap between the back plate 6 and the photovoltaic cell layer 2, to prevent impurities from intruding into the gap and affecting the power generation efficiency and service life of the tile.

Furthermore, the back plate 6 may be either a rigid back plate or a flexible back plate, and is not specifically limited herein. However, in order to reduce the degree of difficulty in fabrication of the tile, optionally, the back plate 6 is a flexible back plate. The flexible back plate is bendable to adapt to the curvature of the side surface of the photovoltaic cell layer 2 away from the tile body 1, thereby facilitating the attachment and fixing between the back plate 6 and the photovoltaic cell layer 2.

In the embodiment described above, the flexible back plate may be either an aluminum-plastic back plate or a resin back plate, and is not specifically limited herein. Optionally, the flexible back plate is an aluminum-plastic back plate. The aluminum-plastic back plate has a good weather resistance and wear resistance, so that the service life of the tile can be prolonged.

In order to fix the tile to a roof structure, optionally, as shown in FIG. 1 and FIG. 3, the mounting section 32 is provided with a fixing hole 8, the fixing hole 8 is configured to allow a connector to pass therethrough, with the connector capable of fixing the tile to the roof structure. In this way, the tile can be fixed to the roof structure through the fixing hole 8.

In order to ensure the structural stability and light transmittance of the tile body 1, optionally, the tile body 1 is a tile body made of ultra-clear tempered glass. The ultra-clear tempered glass has good structural stability, long lifetime, and good light transmittance, so that the power generation efficiency of the tile can be improved.

An embodiment of the present disclosure further provides a tile assembly which comprises the tiles described above.

The tiles are plural in number, and two adjacent tiles are lap-jointed together. In this way, the lap-jointing of a plurality of tiles can be achieved to cover the roof surface.

Specifically, in two adjacent tiles, one of the tiles is a first tile, and the other tile is a second tile, the convex side surface of the fixing section of the jacket of the first tile is attached and fixed to the concave side surface of the first end of the tile body of the first tile, and at the same time, the convex side surface of the mounting section of the jacket of the first tile is attached to the concave side surface of the second end of the tile body of the second tile, the convex side surface of the fixing section of the jacket of the second tile is attached and fixed to the concave side surface of the first end of the tile body of the second tile, and the convex side surface of the mounting section of the jacket of the second tile is attached to the concave side surface of the second end of the tile body of another tile. In the same way, the tiles are sequentially lap-jointed, so that the plurality of tiles can be lap-jointed to form a row of linear tile assemblies, and the entire roof surface can be covered when multiple rows of tile assemblies are placed on the roof surface.

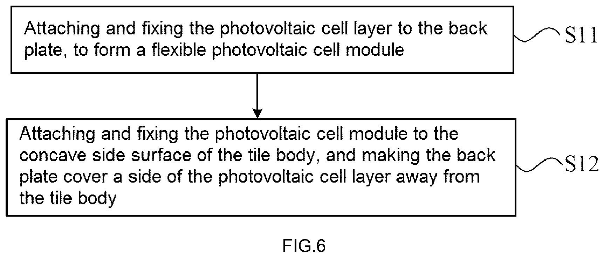

Referring to FIG. 6, an embodiment of the present disclosure further provides a method of fabricating a tile, the tile comprising an arc-shaped tile body, a flexible photovoltaic cell layer, and a flexible back plate, the photovoltaic cell layer being disposed on a concave side surface of the tile body, the back plate covering and being fixed to a side surface of the photovoltaic cell layer away from the tile body, the method comprising:

Step 11, attaching and fixing the photovoltaic cell layer to the back plate, to form a flexible photovoltaic cell module; and

Step 12, attaching and fixing the photovoltaic cell module onto the concave side surface of the tile body, and making the back plate cover a side of the photovoltaic cell layer away from the tile body.

The method of fabricating a tile according to an embodiment of the present disclosure comprises: attaching and fixing the photovoltaic cell layer to the back plate to form a flexible photovoltaic cell module; and attaching and fixing the photovoltaic cell module onto the concave side surface of the tile body, and making the back plate cover a side of the photovoltaic cell layer away from the tile body. In this way, the number of operations of attaching the flexible layer to the arcuate surface during the fabrication process of the tile can be reduced, thereby reducing the degree of difficulty in fabrication of the tile.

An embodiment of the present disclosure further provides a method of fabricating the tile described above, the method comprising: forming a drainage groove in the convex side surface of the jacket; and attaching and fixing the convex side surface of the fixing section of the jacket to the concave side surface of the first end of the tile body, so that the mounting section of the jacket protrudes out from the end surface of the first end of the tile body.

In this way, the finished tile has a drainage groove, thereby preventing penetration of rainwater beneath the tile so as to improve the rainproof property of the tile.

During the molding process, the jacket may be molded in one operation by a mold, that is to say, the fixing section, the mounting section, and the drainage groove located between the fixing section and the mounting section can be simultaneously molded by the mold. Alternatively, an arc-shaped jacket is first molded, and then a drainage groove is formed by machining its convex side surface, or the entire jacket is molded by 3D printing technology.

### In some embodiments:

Referring to FIG. 1, the tile shown in FIG. 1 comprises an arc-shaped tile body 1 and an arc-shaped jacket 3, the tile body 1 comprises a first end 11 and a second end 12, the first end 11 and the second end 12 are two ends of the tile body 1 in its own length direction, the jacket 3 is attached to and disposed on a concave side surface of the tile body 1, and meanwhile the jacket 3 is provided with a fixing hole 8, the jacket 3 is further provided thereon with an elastic layer 5, and the elastic layer 5 is capable of elastically supporting another tile lap-jointed on the jacket 3.

Referring to FIG. 2, the tile shown in FIG. 2 comprises an arc-shaped tile body 1, an arc-shaped jacket 3, an elastic layer 5, a first adhesive layer 4, a photovoltaic cell layer 2, a second adhesive layer 7, and a back plate 6; the tile body 1 comprises a first end 11 and a second end 12, and the first end 11 and the second end 12 are two ends of the tile body 1 in its own length direction; the jacket 3 comprises a fixing section 31 and a mounting section 32 sequentially disposed along the length direction of the jacket, a convex side surface of the fixing section 31 is attached and fixed to a concave side surface of the first end 11 of the tile body 1, the mounting section 32 protrudes out from an end surface of the first end 11 of the tile body 1, and a convex side surface of the mounting section 32 can be attached to the concave side surface of the second end 12 of the tile body 1 of another tile, and meanwhile, the jacket 3 further comprises a stop 33, the stop 33 is located between the fixing section 31 and the mounting section 32, and the stop 33 abuts against the end surface of the first end 11 of the tile body 1; the elastic layer 5 is disposed on the convex side surface of the mounting section 32; the photovoltaic cell layer 2 is adhered to and covers the concave side surface of the tile body 1 by a whole layer of the first adhesive layer 4, and the back plate 6 is adhesively fixed to a side surface of the photovoltaic cell layer 2 away from the tile body 1 by a whole layer of the second adhesive layer 7.

Referring to FIG. 3, in the tile shown in FIG. 3, the fixing section 31 of the jacket 3 is attached and fixed onto the concave side surface of the first end 11 of the tile body 1, while the mounting section 32 of the jacket 3 protrudes out from the end surface of the first end 11 of the tile body 1, the mounting section 32 is covered with an elastic layer 5, and meanwhile, the mounting section 32 is provided with a fixing hole 8, the convex side surface of the jacket 3 is further provided thereon with a drainage groove 34, the drainage groove 34 is located between the fixing section 31 and the mounting section 32, and the drainage groove 34 extends in the width direction of the jacket 3.

Referring to FIG. 4, in the tile shown in FIG. 4, the tile body 1, the photovoltaic cell layer 2, and the back plate 6 are sequentially disposed.

Referring to FIG. 5, in the tile shown in FIG. 5, the fixing section 31 of the jacket 3 is attached and fixed onto the concave side surface of the first end 11 of the tile body 1, and meanwhile, the fixing section 31 abuts against the back plate 6; the fixing section 31, the stop 33, the drainage groove 34 and the mounting section 32 are sequentially disposed in the direction from the fixing section 31 to the mounting section 32, and the mounting section 32 is provided thereon with an elastic layer 5 and a fixing hole 8; and the photovoltaic cell layer 2 is located between the tile body 1 and the back plate 6.

Referring to FIG. 6, the method of fabricating a tile shown in FIG. 6 comprises:

Step 11, attaching and fixing the photovoltaic cell layer to the back plate, to form a flexible photovoltaic cell module; and

Step 12, attaching and fixing the photovoltaic cell module onto the concave side surface of the tile body, and making the back plate cover a side of the photovoltaic cell layer away from the tile body.

The embodiments of the present disclosure include, for example, the following advantageous effects compared to the prior art:

The tile according to embodiments of the present disclosure, having improved rainproof property, comprises an arc-shaped tile body and an arc-shaped jacket, wherein the tile body comprises a first end and a second end, and the first end and the second end are two ends of the tile body in its own length direction; the jacket comprises a fixing section and a mounting section sequentially disposed along the length direction of the jacket, a convex side surface of the fixing section is attached and fixed to a concave side surface of the first end of the tile body, the mounting section protrudes out from an end surface of the first end of the tile body, and a convex side surface of the mounting section can be attached to a concave side surface of the second end of the tile body of another tile. In this way, when the tile is used to cover a roof surface, the tile may be placed with the convex side surface facing upward and the concave side surface facing downward, and at the same time, the concave side surface of the second end of the tile body of a tile is made to be lap-jointed on the convex side surface of the mounting section of another tile, thereby sequentially achieving the lap-jointing of a plurality of tiles to cover the roof surface. Moreover, the convex side surface of the jacket is provided thereon with a drainage groove, the drainage groove is located between the fixing section and the mounting section, and the drainage groove extends along the width direction of the jacket, therefore rainwater entering from a gap between two tiles which are lap-jointed together may be discharged to two sides of the tile under the action of the drainage groove, and discharged by the drainage groove provided on two sides of the tile, thereby preventing penetration of rainwater beneath the tile so as to improve the rainproof property of the tile.

A tile assembly according to embodiments of the present disclosure, having improved rainproof property, comprises the tiles described above and has all the functions of the tile.

A method of fabricating a tile according to embodiments of the present disclosure can produce tiles having improved rainproof property. The fabricating method comprises: attaching and fixing the photovoltaic cell layer to the back plate to form a flexible photovoltaic cell module; and attaching and fixing the photovoltaic cell module to the concave side surface of the tile body, and making the back plate cover a side of the photovoltaic cell layer away from the tile body. In this way, the number of operations of attaching the flexible layer to the arcuate surface during the fabrication process of the tile can be reduced, thereby reducing the degree of difficulty in fabrication of the tile.

A method of fabricating a tile according to embodiments of the present disclosure comprises: forming a drainage groove in the convex side surface of the jacket; and attaching and fixing the convex side surface of the fixing section of the jacket to the concave side surface of the first end of the tile body, so that the mounting section of the jacket protrudes out from the end surface of the first end of the tile body. In this way, the finished tile has a drainage groove, thereby preventing penetration of rainwater beneath the tile so as to improve the rainproof property of the tile.

The above description is merely illustrative of the specific embodiments of the present disclosure, but the scope of protection of the present disclosure is not limited thereto. Any variations or substitutions that can be readily conceived by those skilled in the art within the technical scope disclosed in the present disclosure should be encompassed within the scope of protection of the present disclosure. Therefore, the scope of protection of the present disclosure should be determined by the protection scope of the claims.

### Industrial Applicability

As described above, the present disclosure provides a tile, a tile assembly, and a method of fabricating a tile. The tile has a simple structure and low cost, and rainwater entering from a gap between two tiles which are lap-jointed together can be discharged to two sides of the tile under the action of a drainage groove, so that the rainproof property of the tile is improved.

## Claims

1. A tile, **characterized by** comprising:
an arc-shaped tile body (1), wherein the tile body comprises a first end (11) and a second end (12), and the first end (11) and the second end (12) are two ends of the tile body in a length direction of the tile body; and
an arc-shaped jacket (3), wherein the jacket comprises a fixing section (31) and a mounting section (32) sequentially disposed in a length direction of the jacket (3), wherein a convex side surface of the fixing section (31) is attached and fixed to a concave side surface of the first end (11) of the tile body (1), the mounting section (32) protrudes out from an end surface of the first end (11) of the tile body (1), a convex side surface of the mounting section (32) can be attached to a concave side surface of a second end of a tile body of another tile, the convex side surface of the jacket (3) is provided thereon with a drainage groove (34), the drainage groove (34) is located between the fixing section (31) and the mounting section (32), and the drainage groove (34) extends in a width direction of the jacket (3).

2. The tile according to claim 1, **characterized in that** a sectional shape of the drainage groove (34) is a semicircle, a square or a triangle, and preferably the arc-shaped tile body (1) is a semicircular tile, a combined tile or a ridge tile.

3. The tile according to claim 1 or 2, **characterized in that** the convex side surface of the fixing section (31) and the concave side surface of the first end (11) of the arc-shaped tile body (1) are adhesively fixed to each other by a foam adhesive or a silica gel, or fixed to each other by a screw.

4. The tile according to any one of claims 1-3, **characterized in that** the drainage groove (34) runs through the jacket (3) in the width direction of the jacket (3).

5. The tile according to any one of claims 1-4, **characterized in that** the jacket (3) further comprises a stop (33), the stop (33) is located between the fixing section (31) and the drainage groove (34), and the stop (33) is configured to abut against the end surface of the first end of the tile body .

6. The tile according to any one of claims 1-4, **characterized in that** the jacket (3) further comprises a stop (33), the stop (33) is located between the fixing section (31) and the mounting section (32), and the stop (33) is configured to abut against the end surface of the first end of the tile body.

7. The tile according to any one of claims 1-6, **characterized in that** an elastic layer (5) is provided on the convex side surface of the mounting section (32), and preferably, the elastic layer (5) is an elastic layer made of rubber, silica gel, or sponge.

8. The tile according to any one of claims 1-7, **characterized in that** the tile body (1) is light-transmissible, and a photovoltaic cell layer (2) is provided on the concave side surface of the tile body (1).

9. The tile according to any one of claims 1-8, **characterized in that** the photovoltaic cell layer (2) is attached onto the concave side surface of the tile body, or the photovoltaic cell layer (2) is formed directly on the concave side surface of the tile body, or the photovoltaic cell layer (2) is adhered to and covers the concave side surface of the tile body by using a whole layer of a first adhesive layer (4), and preferably the photovoltaic cell layer (2) is a flexible photovoltaic cell layer.

10. The tile according to any one of claims 1-9, **characterized in that** the tile body (1) is a tempered glass tile body or a polycarbonate tile body.

11. The tile according to any one of claims 8-10, **characterized in that** the tile further comprises a back plate (6), wherein the back plate (6) covers and is fixed onto a side surface of the photovoltaic cell layer (2) away from the tile body, and preferably, the back plate (6) is a flexible back plate.

12. The tile according to any one of claims 1-11, **characterized in that** the mounting section (32) is provided with a fixing hole (8), with the fixing hole (8) configured to allow a connector to pass therethrough, wherein the connector is capable of fixing the tile to a roof structure.

13. A tile assembly, **characterized by** comprising tiles according to any one of claims 1-12.

14. A method of fabricating a tile, **characterized in that** the tile comprises an arc-shaped tile body, a flexible photovoltaic cell layer and a flexible back plate, the photovoltaic cell layer is disposed on a concave side surface of the tile body, the back plate covers and is fixed to a side surface of the photovoltaic cell layer away from the tile body, and the method comprises:
attaching and fixing the photovoltaic cell layer to the back plate, to form a flexible photovoltaic cell module; and
attaching and fixing the photovoltaic cell module to the concave side surface of the tile body, and making the back plate cover a side of the photovoltaic cell layer away from the tile body.

15. The method of fabricating a tile according to claim 14, **characterized in that** the tile further comprises an arc-shaped jacket, and the method further comprises:
forming a drainage groove in a convex side surface of the jacket; and
attaching and fixing the convex side surface of a fixing section of the jacket to a concave side surface of a first end of the tile body, so that a mounting section of the jacket protrudes out from an end surface of the first end of the tile body.
